# FASCICULE DE BREVET EUROPEEN

(11) **EP 2 981 561 B1**
(45) Date de publication et mention de la délivrance du brevet: **16.08.2017**
(21) Numéro de dépôt: 14718685.2
(22) Date de dépôt: 27.03.2014
(51) Int. Cl.: C08F 214/22, C08J 5/22, H01L 41/193, C08F 214/18, C08F 230/02, C08F 222/02, C08F 220/06, C09D 127/16, C08J 5/18

(54) **COPOLYMERES CONTENANT DU FLUORURE DE VINYLIDENE ET DU TRIFLUOROETHYLENE**
VINYLIDENFLUORID- TRIFLUORETHYLENHALTIGE POLYMERE
COPOLYMERS CONTAINING VINYLIDENE FLUORIDE AND TRIFLUOROETHYLENE

(30) Priorité: 03.04.2013 FR 1352981
(43) Date de publication de la demande: 10.02.2016
(73) Titulaire: Arkema France, 92700 Colombes (FR); Centre National de la Recherche Scientifique, 75794 Paris Cedex 16 (FR); Université Montpellier 2, Sciences et Techniques, 34095 Montpellier Cedex 5 (FR)
(72) Inventeur: AMEDURI, Bruno, F-34000 Montpellier (FR); ALAAEDDINE, Ali, Hadath-Beyrouth (LB)
(74) Mandataire: Albani, Dalila
(86) Numéro de dépôt international: PCT/FR2014/050721
(87) Numéro de publication internationale: WO 2014/162080

(56) Documents cités:
- EP-A1- 1 748 053

## Description

### DOMAINE DE L'INVENTION

La présente invention concerne des copolymères à base de fluorure de vinylidène (VDF), de trifluoroéthylène (TrFE) et d'au moins un tiers monomère, ainsi qu'un procédé de préparation de ces copolymères.

### ARRIERE-PLAN TECHNIQUE

Les polymères fluorés représentent une classe de composés ayant des propriétés remarquables pour un grand nombre d'applications, depuis la peinture ou les revêtements spéciaux jusqu'aux joints d'étanchéité, en passant par l'optique, la microélectronique et la technologie membranaire. Parmi ces polymères fluorés, les copolymères sont particulièrement intéressants en raison de leur diversité, de leur morphologie, de leurs propriétés exceptionnelles et de leur versatilité.

L'article de Yagi et al. dans Polymer Journal 6:429-436 (1979) décrit une copolymérisation conventionnelle de fluorure de vinylidène avec du trifluoroéthylène. Ces copolymères présentent des propriétés piézoélectriques particulièrement intéressantes, comme cela est discuté dans l'article de Higashihata et al. dans Ferroelectrics 2:85-92 (1981).

Les articles de Wang et al. dans Macromolecules 39:4268-4271 (2006), de Lu et al. dans Macromolecules 39:6962-6968 (2006), de Lu et al. dans J. Am. Chem. Soc. 128:8120-8121 (2006) et de Zhang et al. dans Macromolecules 40:783-785 (2007) décrivent un procédé de préparation de terpolymères de fluorure de vinylidène, de trifluoroéthylène et de chlorotrifluoroéthylène (CTFE) par une copolymérisation de fluorure de vinylidène avec du CTFE suivie d'une réduction des atomes de chlore des unités de CTFE.

Par ailleurs, il a été également proposé des techniques de copolymérisation radicalaire contrôlée, c'est-à-dire permettant d'obtenir un contrôle de la masse molaire et de l'indice de polymolécularité des polymères.

Le document US 6,355,749 décrit la préparation de terpolymères de fluorure de vinylidène, de trifluoroéthylène et d'un comonomère tel que le CTFE ou l'HFP, selon un procédé de copolymérisation contrôlée au moyen de composés boranes en présence d'oxygène. De même, l'article de Chung et al. dans Macromolecules 35:7678-7684 (2002) décrit la fabrication de terpolymères de fluorure de vinylidène, de trifluoroéthylène et d'un comonomère chloré (CTFE, CDFE ou 2-chloro-1,1,-trifluoroéthylène, VC ou chlorure de vinyle, CFE ou 1,1-chlorofluoroéthylène) également selon une copolymérisation contrôlée au moyen de composés boranes. Un comonomère fluoré (VF ou fluorure de vinyle, HFP) est également utilisé à titre de référence. Cette technique est difficile à mettre en oeuvre en pratique en raison du coût élevé des composés boranes et des risques d'explosion qu'ils engendrent.

D'autres méthodes de copolymérisation radicalaire contrôlée reposent sur l'utilisation de composés xanthates en tant qu'agents de transfert de chaîne, sous l'appellation MADIX, pour « *Macromolecular Design via Interchange of Xanthates* » ; ou encore au moyen de composés iodés en tant qu'agents de transfert de chaîne.

Deux revues résumant des travaux pertinents dans le domaine ont été publiées dans Macromolecules 43:10163-10184 (2010) et dans Chem. Rev. 109:6632-6686 (2009).

Le document US 2008/0081195 décrit des terpolymères, tels que des terpolymères de P(VDF-TrFE-CTFE), présentant deux terminaisons fonctionnelles et préparés par polymérisation contrôlée par des agents de transfert boranes ou di-iodés.

L'article de Li et al. dans J. Appl. Polym. Sci. 122:3007-3015 (2011) décrit la synthèse et la cristallisation de terpolymères P(VDF-TrFE-CTFE).

L'article de Saint Loup et al. dans Macromolecules 35:1524-1536 (2002) décrit la copolymérisation de VDF et HFP ainsi que la terpolymérisation de VDF, HFP et CTFE initiées par le peroxyde d'hydrogène.

Les propriétés de terpolymères P(VDF-TrFE-CFE) et P(VDF-TrFE-CTFE) sont explorées dans les articles de Xu et al. dans Appl. Phys. Lett. 78:2360-2362 (2001) ; de Jeong et al., dans Appl. Phys. Lett. 85:4857-4859 (2004) ; de Claude et al. dans Appl. Phys. Lett. 91:212904 (2007) ; et de Claude et al. dans Chem. Mater. 20:2078-2080 (2008).

L'article de Zhu et al. dans Macromolecules 45:2937-2954 (2012) décrit les propriétés ferroélectriques de plusieurs polymères de la famille du polyfluorure de vinylidène (PVDF), et notamment de terpolymères P(VDF-TrFE-CDFE), P(VDF-TrFE-CTFE), P(VDF-TrFE-HFP) et P(VDF-TrFE-CFE).

Il existe toutefois toujours un besoin de mettre au point de nouveaux copolymères fluorés, et notamment de nouveaux copolymères à base de VDF et de TrFE.

### RESUME DE L'INVENTION

L'invention concerne en premier lieu un copolymère obtenu par copolymérisation de fluorure de vinylidène, de trifluoroéthylène et d'au moins un tiers monomère, ledit tiers monomère ayant une masse molaire supérieure à 100 g/mol et répondant à la formule : 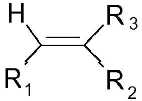 dans laquelle R₁ représente un atome d'hydrogène ou un atome de fluor, et R₂ et R₃ sont choisis, indépendamment l'un de l'autre parmi CI, F, CF₃, et les groupements fonctionnels sélectionnés parmi les groupements phosphonate, acide carboxylique, SO₂X (où X représente F, OK, ONa, OH), ou Si(OR)₃ (R représentant un groupement méthyle, éthyle ou isopropyle).

Selon un mode de réalisation, le tiers monomère est choisi parmi le 2,3,3,3-tétrafluoropropène, le 2-chloro-3,3,3-trifluoropropène, l'acide α-β-difluoroacrylique, l'acide 2-(trifluoro)méthacrylique et le diméthylvinylphosphonate. Selon un mode de réalisation :
- la proportion molaire de motifs issus du monomère fluorure de vinylidène est de 40 à 90 %, de préférence de 55 à 80 % ;
- la proportion molaire de motifs issus du monomère trifluoroéthylène est de 5 à 50 %, de préférence de 10 à 40 % ; et
- la proportion molaire de motifs issus d'au moins un tiers monomère est de 1 à 20 %, de préférence de 2 à 18 %.

L'invention a également pour objet un procédé de préparation d'un copolymère, comprenant une étape de copolymérisation d'un mélange réactionnel de fluorure de vinylidène, de trifluoroéthylène et d'au moins un tiers monomère ayant une masse molaire supérieure à 100 g/mol, le tiers monomère répondant à la formule : 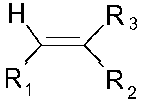 dans laquelle R₁ représente un atome d'hydrogène ou un atome de fluor, et R₂ et R₃ sont choisis, indépendamment l'un de l'autre parmi CI, F, CF₃, et les groupements fonctionnels sélectionnés parmi les groupements phosphonate, acide carboxylique, SO₂X (où X représente F, OK, ONa, OH), ou Si(OR)₃ (R représentant un groupement méthyle, éthyle ou isopropyle).

Selon un mode de réalisation, le tiers monomère est choisi parmi le 2,3,3,3-tétrafluoropropène (ou 1234yf), le 2-chloro-3,3,3-trifluoropropène, l'acide α-β-difluoroacrylique, l'acide 2-(trifluoro)méthacrylique et le diméthylvinylphosphonate. Selon un mode de réalisation :
- la proportion molaire de fluorure de vinylidène dans le mélange réactionnel est de 40 à 90 %, de préférence de 55 à 80 % ;
- la proportion molaire de trifluoroéthylène dans le mélange réactionnel est de 5 à 50 %, de préférence de 10 à 40 % ; et
- la proportion molaire de tiers monomère(s) dans le mélange réactionnel est de 1 à 20 %, de préférence de 2 à 18 % ;
les proportions molaires étant rapportées à la somme du fluorure de vinylidène, du trifluoroéthylène et du tiers monomère.

Selon un mode de réalisation, le mélange réactionnel est dépourvu d'agent de transfert de chaîne.

Selon un mode de réalisation, le mélange réactionnel consiste essentiellement en, et de préférence consiste en, un mélange de fluorure de vinylidène, de trifluoroéthylène, d'au moins un tiers monomère, d'amorceur radicalaire, et de solvant et / ou d'eau.

Selon un mode de réalisation, le mélange réactionnel est chauffé jusqu'à une température de démarrage de réaction comprise entre 60 et 90°C, de préférence entre 70 et 80°C, et plus particulièrement entre 72 et 76°C.

Selon un mode de réalisation, le copolymère décrit ci-dessus est préparé par le procédé susmentionné.

L'invention a également pour objet un film ou une membrane comprenant au moins un copolymère tel que décrit ci-dessus.

L'invention a également pour objet un dispositif piézoélectrique comprenant un tel film.

L'invention a également pour objet un dispositif ferroélectrique comprenant un tel film.

L'invention a également pour objet un dispositif pyroélectrique comprenant un tel film.

L'invention a également pour objet un revêtement comprenant un tel film.

La présente invention permet de répondre aux besoins existants dans l'état de la technique.

L'invention est particulièrement utile pour la fabrication de composés piézoélectriques, ferroélectriques ou pyroélectriques.

### BREVE DESCRIPTION DES FIGURES

La **figure 1a** représente un spectre de RMN ¹H dans de l'acétone-d6 (20°C, 400 MHz) d'un terpolymère poly(VDF-*ter*-TrFE-*ter*-1234yf) (voir l'exemple 1).
La **figure 1b** représente un spectre de RMN ¹⁹F du même terpolymère dans de l'acétone-d6 (20°C, 400 MHz).
La **figure 2a** représente un spectre de RMN ¹H dans de l'acétone-d6 (20°C, 400 MHz) d'un terpolymère poly(VDF-*ter*-TrFE-*ter*-1234yf) (voir l'exemple 2).
La **figure 2b** représente un spectre de RMN ¹⁹F du même terpolymère dans de l'acétone-d6 (20°C, 400 MHz).
La **figure 3a** représente un spectre de RMN ¹H dans de l'acétone-d6 (20°C, 400 MHz) d'un terpolymère poly(VDF-*ter*-TrFE-*ter*-1234yf) (voir l'exemple 3).
La **figure 3b** représente un spectre de RMN ¹⁹F du même terpolymère dans de l'acétone-d6 (20°C, 400 MHz).
La **figure 4a** représente un spectre de RMN ¹H dans de l'acétone-d6 (20°C, 400 MHz) d'un terpolymère poly(VDF-*ter*-TrFE-*ter*-1234yf) (voir l'exemple 4).
La **figure 4b** représente un spectre de RMN ¹⁹F du même terpolymère dans de l'acétone-d6 (20°C, 400 MHz).
La **figure 5a** représente un spectre de RMN ¹H dans de l'acétone-d6 (20°C, 400 MHz) d'un terpolymère poly(VDF-*ter*-TrFE-*ter*-1234yf) (voir l'exemple 5).
La **figure 5b** représente un spectre de RMN ¹⁹F du même terpolymère dans de l'acétone-d6 (20°C, 400 MHz).
La **figure 6a** représente un spectre de RMN ¹H dans de l'acétone-d6 (20°C, 400 MHz) d'un terpolymère poly(VDF-*ter*-TrFE-*ter*-2-chloro-3,3,3-trifluoropropène) (voir l'exemple 6).
La **figure 6b** représente un spectre de RMN ¹⁹F du même terpolymère dans de l'acétone-d6 (20°C, 400 MHz).
La **figure 7a** représente un spectre de RMN ¹H dans de l'acétone-d6 (20°C, 400 MHz) d'un terpolymère poly(VDF*-ter-*TrFE*-ter-*diméthylvinylphosphonate) (voir l'exemple 7).
La **figure 7b** représente un spectre de RMN ¹⁹F du même terpolymère dans de l'acétone-d6 (20°C, 400 MHz).
La **figure 8a** représente un spectre de RMN ¹H dans de l'acétone-d6 (20°C, 400 MHz) d'un terpolymère poly(VDF-*ter*-TrFE-*ter*-acide itaconique) (voir l'exemple 8).
La **figure 8b** représente un spectre de RMN ¹⁹F du même terpolymère dans de l'acétone-d6 (20°C, 400 MHz).
La **figure 9a** représente un spectre de RMN ¹H dans de l'acétone-d6 (20°C, 400 MHz) d'un terpolymère poly(VDF-*ter*-TrFE-*ter*-acide α,β-difluoroacrylique) (voir l'exemple 9).
La **figure 9b** représente un spectre de RMN ¹⁹F du même terpolymère dans de l'acétone-d6 (20°C, 400 MHz).

### DESCRIPTION DE MODES DE REALISATION DE L'INVENTION

L'invention est maintenant décrite plus en détail et de façon non limitative dans la description qui suit.

L'invention prévoit de préparer un copolymère au moyen d'une réaction de polymérisation entre du TrFE, du VDF et au moins un tiers monomère.

Le terme « copolymère » signifie ici un polymère issu de la copolymérisation d'au moins trois types de comonomères, chimiquement différents. Le tiers monomère, qui est distinct de TrFE et de VDF, présente une masse molaire supérieure à 100 g/mol et répond à la formule : 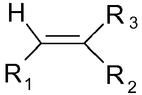 dans laquelle R₁ représente un atome d'hydrogène ou un atome de fluor, et R₂ et R₃ sont choisis, indépendamment l'un de l'autre parmi CI, F, CF₃, et les groupements fonctionnels sélectionnés parmi les groupements phosphonate, acide carboxylique, SO₂X où X représente F, OK, ONa, OH ou Si(OR)₃, R représentant un groupement méthyle, éthyle ou isopropyle. Par « groupement fonctionnel » on entend ici un groupe d'atomes comprenant au moins deux atomes, dont au moins un est différent de C et de H.

Selon un mode de réalisation, les copolymères de l'invention sont des terpolymères constitués de trois comonomères différents.

Selon un autre mode de réalisation, le copolymère de l'invention est constitué de quatre comonomères ayant des structures distinctes.

Les copolymères selon l'invention sont statistiques et linéaires.

De préférence, le tiers monomère présente une masse molaire inférieure ou égale à 150 g/mol, et notamment inférieure ou égale à 145 g/mol ou inférieure ou égale à 140 g/mol.

Selon un mode de réalisation, le tiers monomère est choisi parmi le 2,3,3,3-tétrafluoropropène (ou 1234yf), le 2-chloro-3,3,3-trifluoropropène, l'acide α-β-difluoroacrylique, l'acide 2-(trifluoro)méthacrylique et le diméthylvinylphosphonate. La réaction de polymérisation est de préférence conventionnelle, par opposition à une polymérisation radicalaire contrôlée, c'est-à-dire que la polymérisation est mise en oeuvre sans agent de transfert de chaine.

Par « *agent de transfert de chaîne* » on entend une substance capable de causer un transfert de chaîne dans la réaction de polymérisation. Un transfert de chaîne est un transfert du radical réactif à l'extrémité de la chaîne polymère croissante à une autre molécule. Les composés xanthates, iodés ou boranes sont des exemples d'agents de transfert de chaine. On peut faire référence à l'ouvrage d'Améduri et Boutevin intitulé Well Architectured Fluoropolymers: synthesis, properties and Applications, publié par Elsevier, Amsterdam (2004).

La réaction de polymérisation conventionnelle permet notamment d'obtenir des indices de polymolécularité plus larges que la polymérisation radicalaire contrôlée.

La réaction de polymérisation est effectuée en présence d'un amorceur radicalaire. Celui-ci peut être par exemple le peroxypivalate de tert-butyle (ou TBPPI), le peroxypivalate de tert-amyle, le bis (4-*tert*-butyl cyclohexyl) peroxydicarbonate, les persulfates de sodium, d'ammonium ou de potassium, le peroxyde de benzoyle, l'hydroxy peroxyde de tert-butyle, le peroxyde de tert-butyle ou le 2,5-bis(tert-butylperoxy)-2,5-diméthylhexane.

La réaction est effectuée dans un solvant, qui est par exemple choisi parmi le 1,1,1,3,3-pentafluorobutane, l'acétonitrile, la méthyléthylcétone, le diméthyl carbonate, le 2,2,2-trifluoroéthanol, l'hexafluoroisopropanol, l'acétate de méthyle, l'acétate d'éthyle, la cyclohexanone, l'eau et les mélanges de ceux-ci.

La réaction est de préférence effectuée à une température de 10 à 200°C, de préférence de 35 à 170°C, et à une pression de 10 à 120 bar, de préférence de 20 à 80 bar. Le choix de la température optimale dépend de l'amorceur qui est utilisé. Généralement, la réaction est mise en oeuvre pendant au moins 6 heures, à une température à laquelle le temps de demi-vie de l'amorceur est d'1 heure environ.

Une température de réaction comprise entre 60 et 90°C, de préférence entre 70 et 80°C, et plus particulièrement entre 72 et 76°C est appropriée dans certains modes de réalisation.

Selon un mode de réalisation préféré, la proportion molaire de motifs VDF dans le terpolymère est de 40 à 90 %, de préférence de 55 à 80 %.

Selon un mode de réalisation préféré, la proportion molaire de motifs TrFE dans le terpolymère est de 5 à 50 %, de préférence de 10 à 40 %.

Selon un mode de réalisation préféré, la proportion molaire de motifs issus du tiers monomère dans le terpolymère est de 1 à 20 %, de préférence de2à18%.

La masse molaire du terpolymère obtenu est de préférence de 20.000 à 100.000 g/mol, plus préférentiellement de 20.000 à 80.000 g/mol. Plus la masse molaire est élevée, meilleures sont les propriétés des matériaux obtenus.

L'indice de polymolécularité du terpolymère obtenu est de préférence de 1,4 à 3,5 plus préférentiellement de 1,48 à 2,5.

Les copolymères obtenus selon l'invention sont utiles notamment pour la fabrication d'électrolytes ou pour la fabrication de membranes. Ils sont également utiles pour la fabrication de dispositifs piézoélectriques, ferroélectriques ou pyroélectriques ainsi que de revêtements.

### EXEMPLES

Les exemples suivants illustrent l'invention sans la limiter.

### Exemple 1 - synthèse du poly(VDF-ter-TrFE-ter-1234yf) (VDF : 80 % ; TrFE : 15 % ; 1234yf : 5 % - rapports molaires initiaux)

La synthèse du polymère poly(VDF-*ter*-TrFE-*ter*-1234yf) est réalisée selon le schéma suivant :

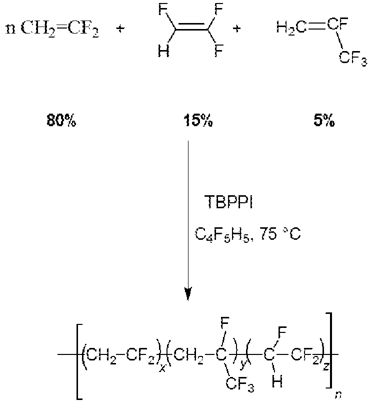

La polymérisation radicalaire est réalisée dans un autoclave de 100 mL Parr Hastelloy équipé d'un manomètre, d'un disque de rupture, et de vannes d'introduction de gaz et de relargage. Un dispositif électronique réglementé contrôle à la fois l'agitation et le chauffage de l'autoclave. Le réacteur est pressurisé à 30 bars d'azote pendant 1 h pour en vérifier l'étanchéité.

Une fois l'azote évacué, le réacteur est placé sous vide pendant 40 min, puis l'amorceur radicalaire (TBPPI, 0,589 g soit 3,38 mmol) et le solvant (60 mL de 1,1,1,3,3-pentafluorobutane) sont introduits. Le réacteur est ensuite refroidi à -60 °C (mélange acétone/azote liquide), puis le 1234yf, (1,5 g soit 0,02 mol), le TrFE (3 g soit 0,038 mol) et le VDF (13,0 g soit 0,203 mol), y sont successivement introduits.

Le réacteur est chauffé progressivement jusqu'à 74°C, et l'évolution de la pression et de la température sont enregistrées. Au cours de la polymérisation, une augmentation de la pression à l'intérieur du réacteur est observée, due à l'exothermie de la réaction, puis une diminution de celle-ci, provoquée par la conversion des monomères fluorés en gazeux en terpolymère souhaité. A 74°C, la pression avoisine 34 bars (une augmentation rapide de la température jusqu'à 78°C est observée). Au cours de l'heure qui suit cet exotherme, la pression passe de 34 bars à 12 bars avec une température maintenue à 74 °C.

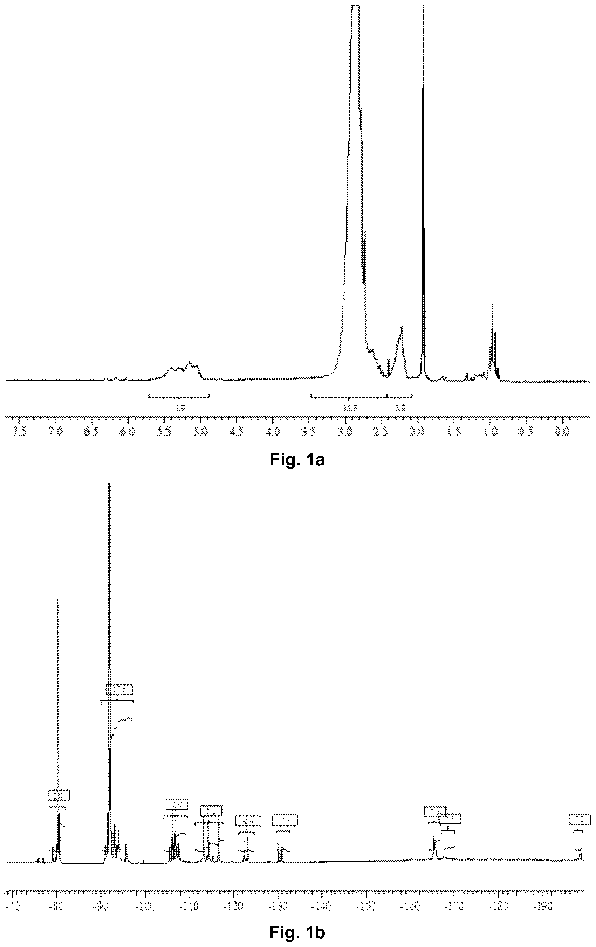

Après réaction et refroidissement, le réacteur est laissé dans la glace pendant 30 min puis dégazé (ce qui permet le relargage des monomères fluorés qui n'ont pas réagi). Après ouverture du réacteur, le solvant est éliminé par distillation puis le produit est précipité dans du pentane froid, filtré, re-dissous dans le minimum d'acétone, re-précipité, filtré et séché sous vide (10⁻² bar, 60 °C) jusqu'à poids constant. Le terpolymère poly(VDF-*ter-*TrFE-*ter*-1234yf), sous forme d'une poudre blanche, est caractérisé par spectroscopie RMN du ¹H (**Figure 1a**) et du ¹⁹F (**Figure 1b**). Le rendement massique (masse de terpolymère recueilli / (sommes des masses des comonomères introduites dans le réacteur)) est de 62%.

### Exemple 2 - synthèse du poly(VDF-ter-TrFE-ter-1234yf) (VDF : 70 % ; TrFE : 25 % ; 1234yf : 5% - rapports molaires initiaux)

La synthèse du polymère poly(VDF-*ter*-TrFE-*ter*-1234yf) est réalisée selon le même protocole que dans l'exemple 1.

Dans le détail, on procède comme précédemment dans un réacteur HC-276 de 100 mL en y introduisant respectivement le TBPPI (0,672 g soit 3,86 mmol) et 60 mL de 1,1,1,3,3-pentafluorobutane. Le réacteur est ensuite refroidi à -60 °C (mélange acétone/azote liquide), puis le 1234yf, (1,66 g soit 0,014 mol), le TrFE (5,94 g soit 0,072 mol) suivi du VDF (13 g soit 0,203 mol) y sont successivement introduits.

Le réacteur est progressivement chauffé jusqu'à 74 °C, et les évolutions de la pression et de la température sont enregistrées. Au cours de la polymérisation, une augmentation de la pression à l'intérieur du réacteur est observée, puis une diminution de celle-ci, provoquée par la conversion des monomères fluorés gazeux en terpolymère. A 74 °C, la pression avoisine 37 bars (exothermie jusqu'à 76 °C). Au cours de l'heure suivant cet exotherme, la pression chute à 13 bars pour une température maintenue à 74 °C.

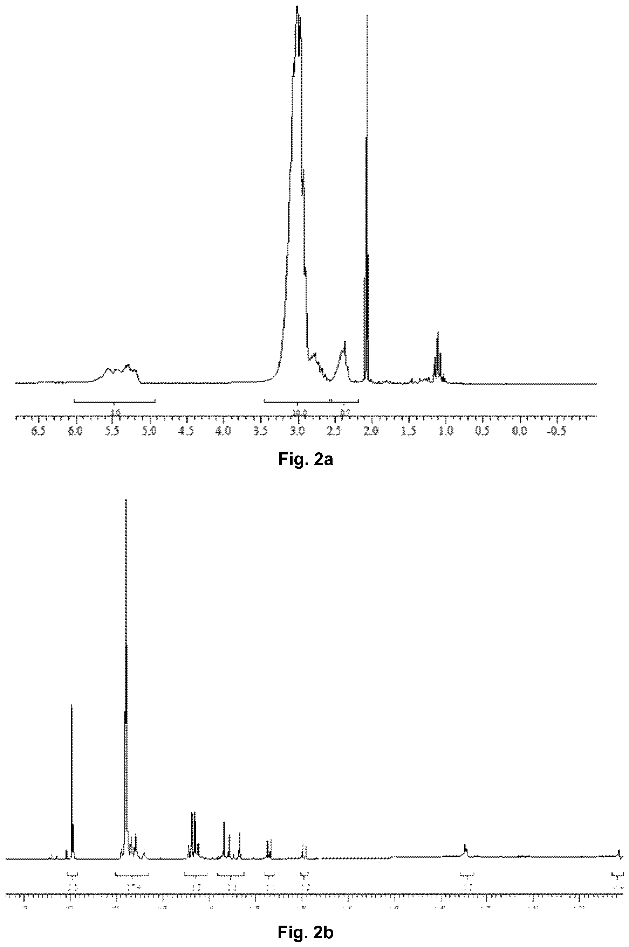

Comme précédemment, après réaction et refroidissement, le réacteur est laissé dans la glace pendant 30 min, puis dégazé. Après ouverture le solvant est distillé. Le produit est précipité dans du pentane froid, filtré et séché sous vide (10⁻² bar, 60 °C) pendant 14 heures. Le terpolymère poly(VDF-*ter*-TrFE-*ter*-1234yf) sous forme de poudre blanche, est caractérisé par spectroscopie RMN du ¹H (**Figure 2a**) et du ¹⁹F (**Figure 2b**). Le rendement massique est de 88%.

### Exemple 3 - synthèse du poly(VDF-ter-TrFE-ter-1234yf) (VDF : 57 % ; TrFE : 33 % ; 1234yf : 10 % - rapports molaires initiaux)

La synthèse du polymère poly(VDF-*ter*-TrFE-*ter*-1234yf) est réalisée selon le même protocole que dans l'exemple 1.

Dans le détail, on procède comme précédemment dans un réacteur HC-276 de 100 mL en y introduisant respectivement le TBPPI (0,689 g soit 5.48 mmol) et 60 mL de 1,1,1,3,3-pentafluorobutane. Le réacteur est ensuite refroidi à -60 °C (mélange acétone/azote liquide), puis le 1234yf, (5 g soit 0,043 mol), le trifluoroéthylène TrFE (11 g soit 0,134 mol) suivi du VDF (15 g soit 0,234 mole) y sont introduits.

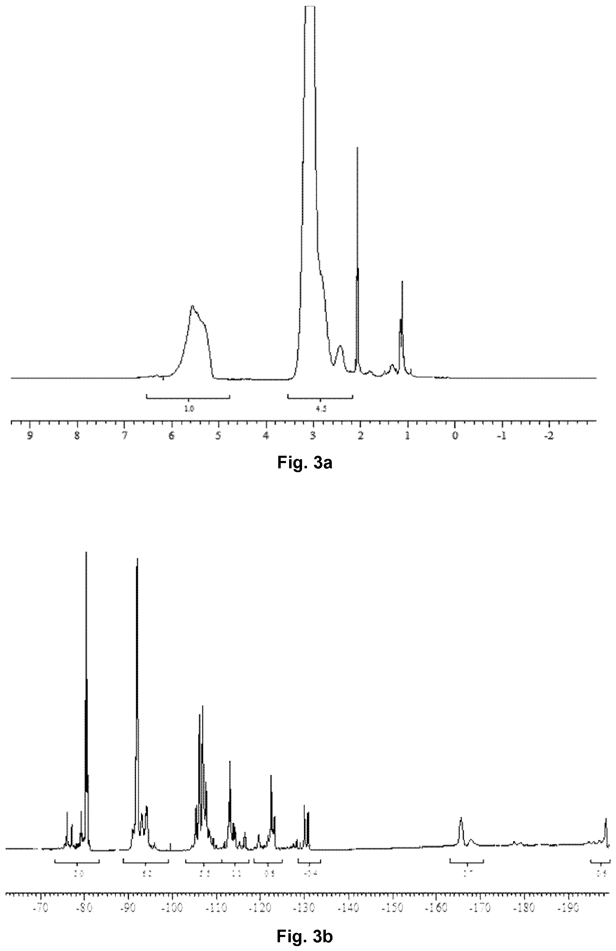

Le réacteur est progressivement chauffé jusqu'à 74°C, et, au cours de la polymérisation, une augmentation de la pression à l'intérieur du réacteur est observée, due à l'exothermie de la réaction, puis une diminution de celle-ci, provoquée par la conversion des monomères fluorés gazeux en polymère souhaité. A 74°C, la pression avoisine 38 bars (exothermie jusqu'à 76°C). Au cours de l'heure suivant cet exotherme, la pression chute à 17 bars pour une température maintenue à 74°C. Comme précédemment, après réaction et refroidissement, le réacteur est laissé dans la glace pendant 30 min puis dégazé. Après ouverture le solvant est distillé. Le produit est précipité dans du pentane froid, filtré, re-dissous, re-précipité et séché sous vide (10⁻² bar, 60°C) pendant 14 heures. Le terpolymère poly(VDF-*ter*-TrFE-*ter-*1234yf) sous forme de poudre blanche, est caractérisé par spectroscopie RMN du ¹H (**Figure 3a**) et du ¹⁹F (**Figure 3b**). Le rendement massique est de 58%.

### Exemple 4 - synthèse du poly(VDF-ter-TrFE-ter-1234yf) (VDF : 60 % ; TrFE : 35 % ; 1234yf : 5 % - rapports molaires initiaux)

La synthèse du polymère poly(VDF-*ter*-TrFE-*ter*-1234yf) est réalisée selon le même protocole que dans l'exemple 1.

Dans le détail, on procède comme précédemment dans un réacteur HC-276 de 100 mL en y introduisant respectivement le TBPPI (0,604 g soit 3,47 mmol) et 60 mL de 1,1,1,3,3-pentafluorobutane. Après refroidissement du réacteur le 1234yf (1,49 g soit 0,013 mol), le TrFE (7,47 g soit 0,091 mol) puis le VDF (10 g soit 0,156 mol) y sont successivement introduits.

Comme précédemment, le réacteur est chauffé à 74°C, montrant une augmentation de la pression à l'intérieur du réacteur, puis une diminution de celle-ci, liée à la conversion des monomères fluorés gazeux en terpolymère souhaité. A 74°C, la pression avoisine les 22 bars (exothermie jusqu'à 76°C). Au cours de l'heure suivant cet exotherme, la pression chute à 8 bars pour une température maintenue à 74 °C.

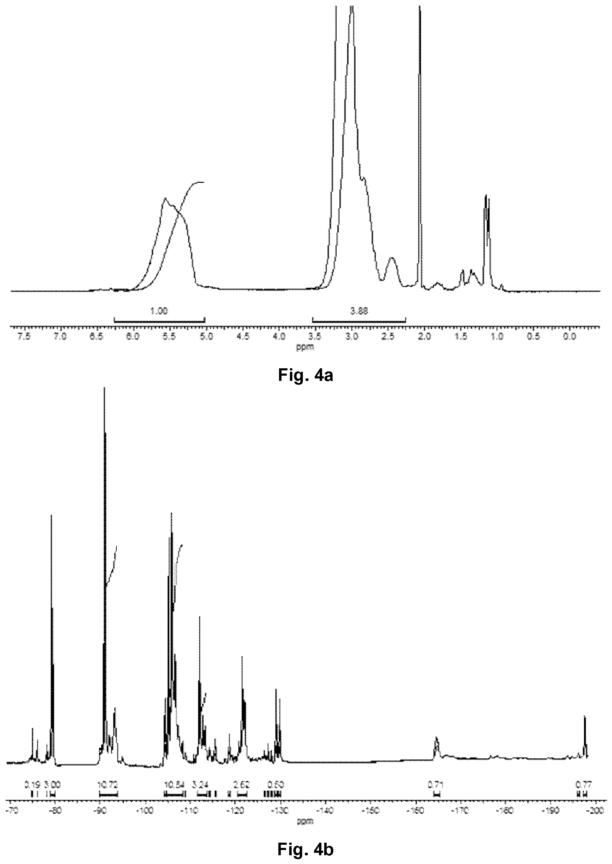

Comme précédemment, après réaction et refroidissement, le réacteur est laissé dans la glace pendant 30 min puis dégazé. Après ouverture le solvant est distillé. Le produit est précipité dans du pentane froid, filtré et séché sous vide (10-² bar, 60°C) pendant 14 heures. Le terpolymère poly(VDF-*ter*-TrFE-*ter*-1234yf) sous forme de poudre blanche, est caractérisé par spectroscopie RMN du ¹H (**Figure 4a**) et du ¹⁹F (**Figure 4b**). Le rendement massique est de 72%.

### Exemple 5 - synthèse du poly(VDF-ter-TrFE-ter-1234yf) (VDF : 58 % ; TrFE : 39 % ; 1234yf : 3 % - rapports molaires initiaux)

La synthèse du polymère poly(VDF-*ter*-TrFE-*ter*-1234yf) est réalisée selon le même protocole que dans l'exemple 1.

Dans le détail, on procède comme précédemment dans un réacteur HC-276 de 100 mL en y introduisant respectivement le TBPPI (0,659 g soit 3,78 mole) et 60 mL de 1,1,1,3,3-pentafluorobutane. Le réacteur est ensuite refroidi puis le 1234yf (2 g soit 0,017 mol), le TrFE (16 g soit 0,195 mol) suivi du VDF (10 g soit 0,296 mol) y sont introduits.

Le réacteur est progressivement chauffé jusqu'à 74°C et, au cours de la polymérisation, une augmentation de la pression qui avoisine 33 bars est suivie d'une chute à 10 bars pour une température maintenue à 74°C. Comme précédemment, après refroidissement, le réacteur est refroidi puis dégazé. Après ouverture et distillation du solvant, le terpolymère est précipité dans du pentane froid, filtré et séché sous vide (10⁻² bar, 60°C).

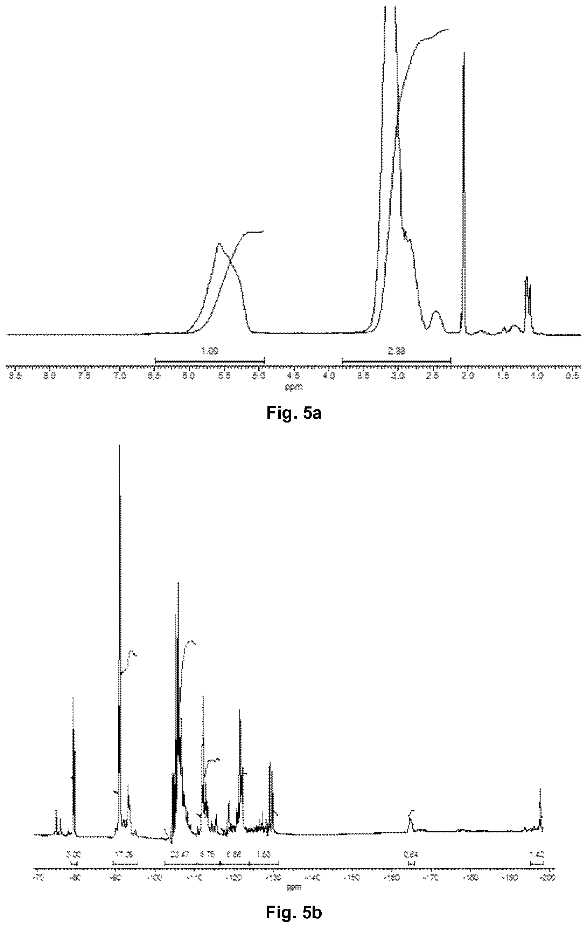

Le terpolymère poly(VDF-*ter*-TrFE-*ter*-1234yf) sous forme de poudre blanche, est caractérisé par spectroscopie RMN du ¹H (**Figure 5a**) et du ¹⁹F (**Figure 5b**). Le rendement est de 69%.

### Exemple 6 : synthèse du terpolymère poly(VDF-ter-TrFE-ter-2-chloro-3,3,3-trifluoropropène) (VDF : 60 % ; TrFE : 35 % ; comonomère : 5 % - rapports molaires initiaux)

La synthèse du polymère poly(VDF-*ter*-TrFE-*ter*-1234yf) est réalisée selon le schéma suivant :

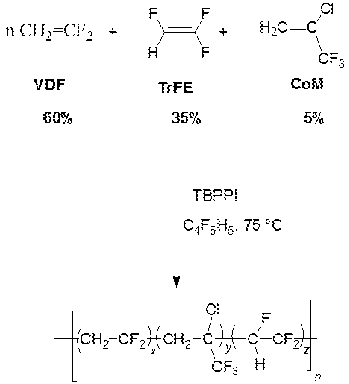

Cette polymérisation est réalisée comme précédemment dans un réacteur de 100 mL en y introduisant respectivement le TBPPI (0,604 g soit 3,47 mol) et 60 mL de 1,1,1,3,3-pentafluorobutane. Le réacteur est ensuite refroidi, puis le 2-chloro-3,3,3-trifluoropropène (1,71 g soit 0,013 mol), le TrFE (7,47 g soit 0,091 mol) suivi du VDF (10 g soit 0,156 mole) y sont successivement introduits.

Le réacteur est chauffé jusqu'à 74°C. Au cours de la polymérisation, une augmentation de la pression à l'intérieur du réacteur est observée (25 bars), suivie d'une diminution de celle-ci (12 bars) pour une température maintenue à 74°C.

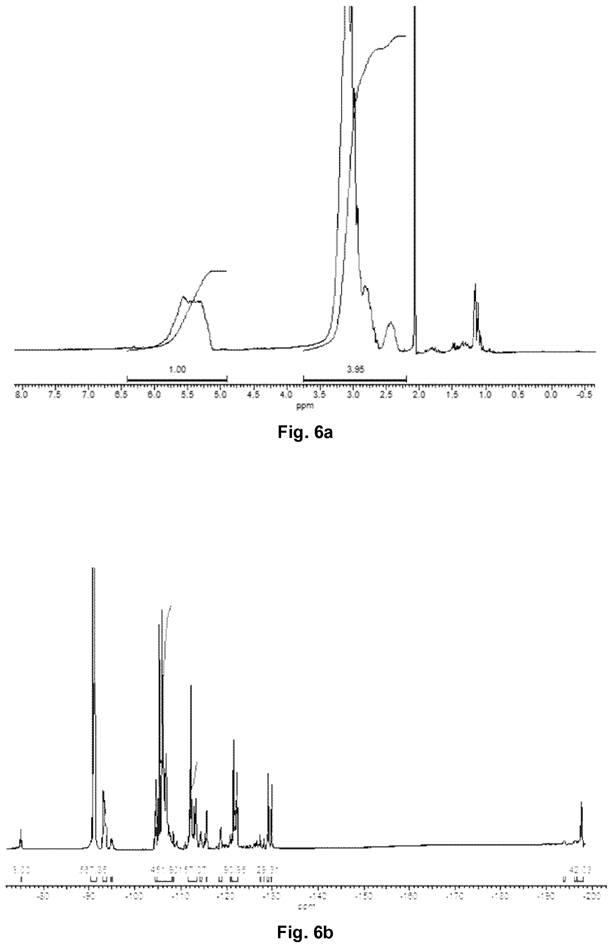

Comme précédemment, après refroidissement, le réacteur refroidi puis dégazé et ouvert. Le solvant est ensuite distillé, puis le terpolymère est précipité dans du pentane froid, filtré, re-dissous, re-précipité et séché sous vide (10-² bar, 60 °C) pendant 14 heures. Le terpolymère poly(VDF-*ter*-TrFE-*ter-*coM*)* sous forme de poudre blanche, est caractérisé par spectroscopie RMN du ¹H (**Figure 6a**) et du ¹⁹F (**Figure 6b**)**.** Le rendement massique est de 87%.

### Exemple 7: synthèse du terpolymère poly(VDF-ter-TrFE-ter-diméthyl vinylphosphonate) (VDF : 60 % ; TrFE : 35 % ; comonomère : 5 % - rapports molaires initiaux)

La synthèse du polymère poly(VDF-*ter*-TrFE-*ter*-diméthyl vinylphosphonate) est réalisée selon le schéma suivant :

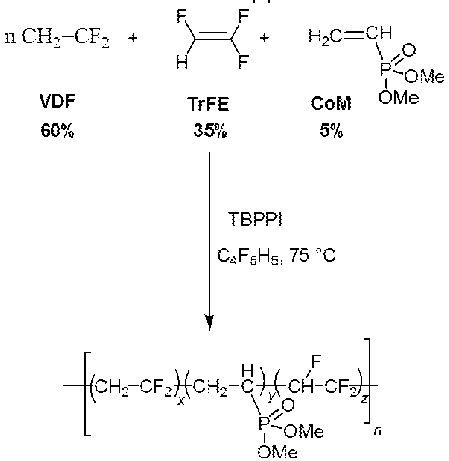

Comme dans les exemples précédents, un réacteur HC-276 de 100 mL est dégazé, mis sous vide et y sont respectivement introduits du TBPPI (0,604 g soit 3,47 mol), du diméthyl vinylphosphonate (1,76 g soit 0,013 mol) et 60 mL de 1,1,1,3,3-pentafluorobutane. Le réacteur est ensuite refroidi, puis le TrFE (7,47 g soit 0,091 mol) suivi du VDF (10 g soit 0,156 mole) y sont ensuite transférés.

Le réacteur est progressivement chauffé jusqu'à 74°C. Au cours de la polymérisation, une augmentation de la pression à l'intérieur du réacteur est observée (22 bars), suivie d'une diminution de celle-ci (17 bars).

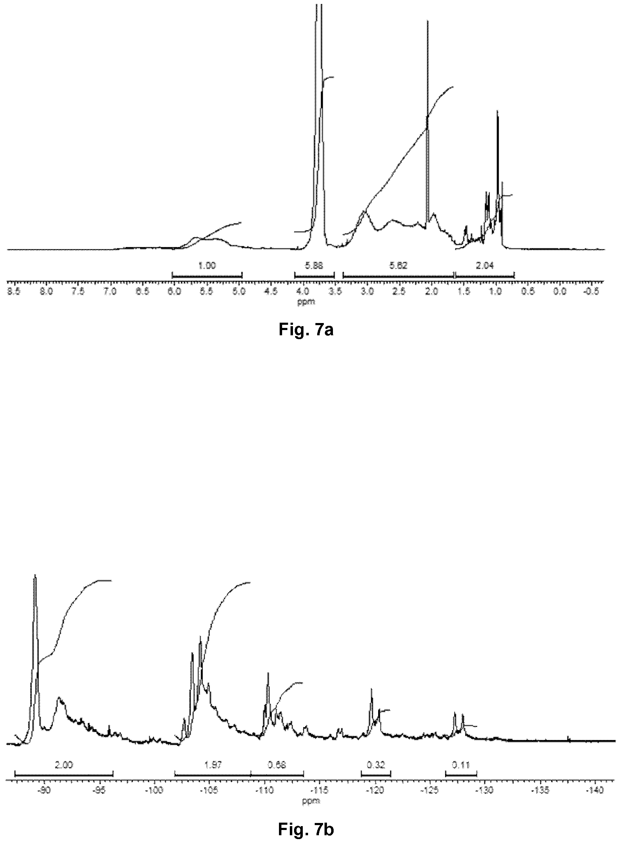

Après réaction, le réacteur est refroidi, dégazé, puis ouvert, et le solvant est ensuite distillé. Le produit est précipité dans du pentane froid, filtré et séché sous vide (10⁻² bar, 60 °C) pendant 14 heures. Le terpolymère poly(VDF-*ter*-TrFE-*ter*-coM) sous forme d'un élastomère clair est caractérisé par spectroscopie RMN du ¹H (**Figure 7a**) et du ¹⁹F (**Figure 7b**). Le rendement massique est de 26%.

### Exemple 8 (pas selon l'invention): synthèse du terpolymère poly(VDF-ter-TrFE-ter-acide itaconique) (VDF: 60%; TrFE: 35%; comonomère: 5% - rapports molaires initiaux)

La synthèse du polymère poly(VDF-*ter*-TrFE-*ter*-acide itaconique) est réalisée selon le schéma suivant :

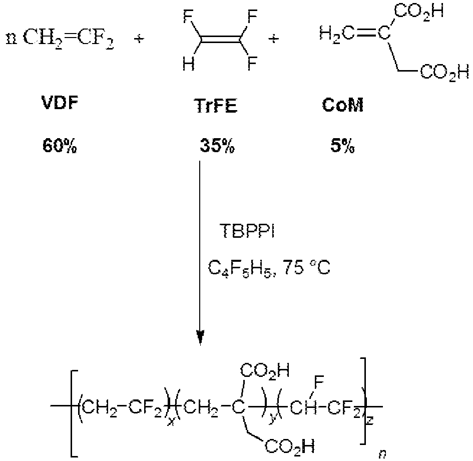

Dans un réacteur HC-276 de 100 mL sont introduits respectivement le TBPPI (0,604 g soit 3,47 mol), l'acide itaconique (1,69 g soit 0.013 mol), 50 mL de 1,1,1,3,3-pentafluorobutane et 10 mL d'eau distillée. Le réacteur est ensuite refroidi, puis le TrFE (7,47 g soit 0,091 mol) suivi du VDF (10 g soit 0,156 mole) y sont transférés.

Le réacteur est progressivement chauffé jusqu'à 74 °C, et on note une augmentation de la pression à 25 bars suivie d'une chute à 13 bars.

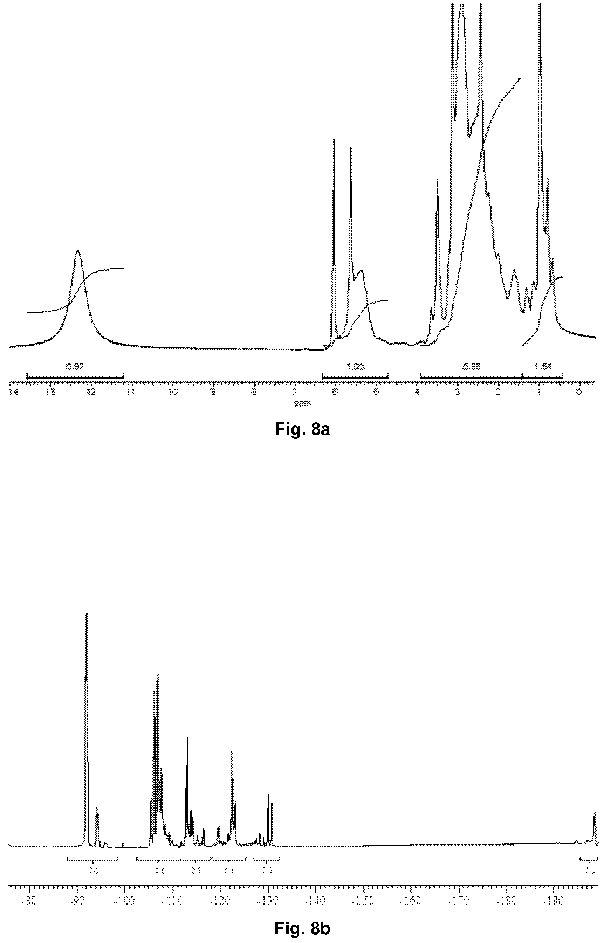

Après réaction et refroidissement, le réacteur est dégazé puis ouvert. Le solvant est distillé. Le produit est précipité dans du pentane froid, filtré et séché sous vide (10⁻² bar, 60 °C) pendant 14 heures. Le polymère poly(VDF-*ter*-TrFE-*ter*-coM) sous forme d'un élastomère blanchâtre est caractérisé par spectroscopie RMN du ¹H (**Figure 8a**) et du ¹⁹F (**Figure 8b**). Le rendement calculé est de 44%.

### Exemple 9: synthèse du terpolymère poly(VDF-ter-TrFE-ter-acide α,β-difluoroacrylique) (VDF : 60 % ; TrFE : 35 % ; comonomère : 5 % - rapports molaires initiaux)

La synthèse du polymère poly(VDF-*ter*-TrFE-*ter*-acide α,β-difluoroacrylique) est réalisée selon le schéma suivant :

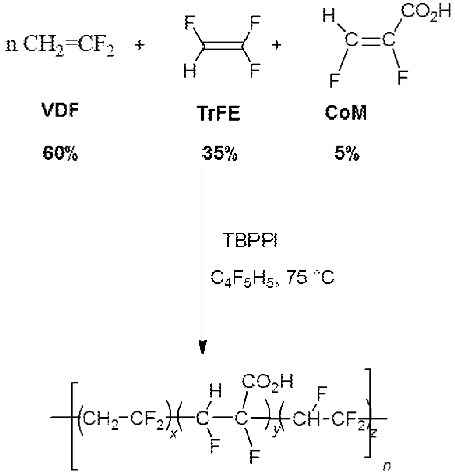

Comme précédemment, un réacteur HC-276 de 100 mL est mis sous vide puis sont introduits respectivement le TBPPI (0,604 g soit 3,47 mol), l'acide α,β-difluoroacrylique (1,40 g soit 0,013 mol) et 60 mL de 1,1,1,3,3-pentafluorobutane. Le réacteur est ensuite refroidi, puis le TrFE (7,47 g soit 0,091 mol) suivi du VDF (10 g soit 0,156 mole) y sont successivement introduits.

Le réacteur est progressivement chauffé jusqu'à 74°C, et une augmentation de la pression est notée (26 bars) puis une chute à 8 bars.

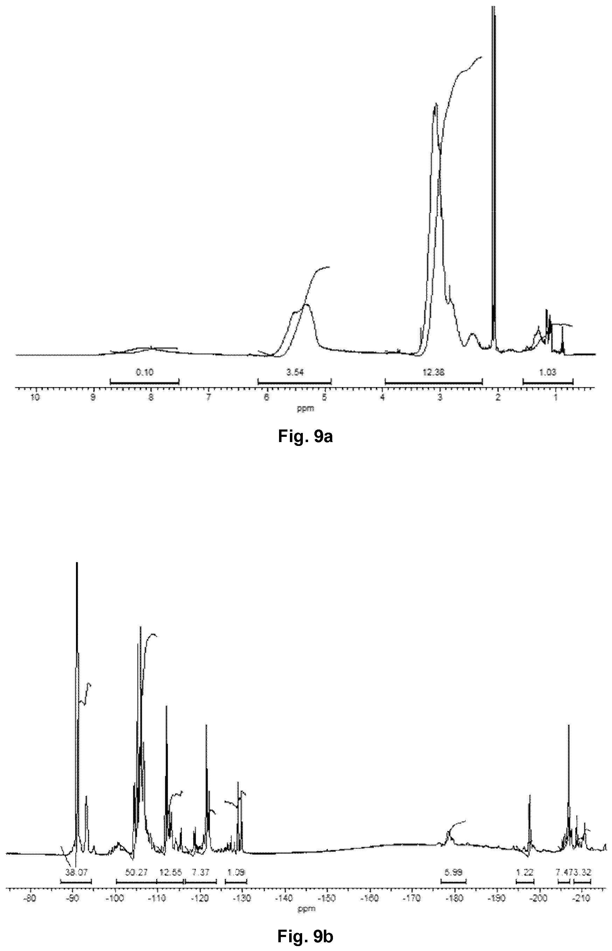

Après réaction et refroidissement, le réacteur est dégazé puis ouvert. Le solvant est ensuite distillé. Le produit est précipité dans du pentane froid, filtré et séché sous vide (10⁻² bar, 60 °C) pendant 14 heures. Le terpolymère poly(VDF-*ter*-TrFE-*ter*-acide α,β-difluoroacrylique) sous forme d'un élastomère blanchâtre est caractérisé par spectroscopie RMN du ¹H (**Figure 9a**) et du ¹⁹F (**Figure 9b**). Le rendement massique est de 79%.

Le tableau suivant résume les conditions et les résultats des synthèses précédentes :

| | **Ex.1** | **Ex.2** | **Ex.3** | **Ex.4** | **Ex.5** | **Ex.6** | **Ex.7** | **Ex.8** | **Ex.9** |
|---|---|---|---|---|---|---|---|---|---|
| VDF init. (%) | 80 | 70 | 57 | 60 | 58 | 60 | 60 | 60 | 60 |
| TrFE init. (%) | 15 | 25 | 33 | 35 | 39 | 35 | 35 | 35 | 35 |
| CoM init. (%) | 5 | 5 | 10 | 5 | 3 | 5 | 5 | 5 | 5 |
| VDF fin. (%) | 81 | 76 | 61 | 66 | 65 | 65 | 50 | 65 | 65 |
| TrFE fin. (%) | 10 | 16 | 23 | 27 | 30 | 33 | 32 | 25 | 30 |
| CoM fin. (%) | 9 | 8 | 16 | 7 | 5 | 2 | 18 | 10 | 5 |
| TBPPI (%) | 1 | 1 | 1 | 1 | 0,5 | 1 | 1 | 1 | 1 |
| Pₘₐₓ (bar) | 34 | 37 | 25 | 20 | 33 | 25 | 25 | 22 | 25 |
| ΔP (bar) | 22 | 24 | 16 | 15 | 23 | 13 | 3 | 5 | 13 |
| Rend. (%) | 62 | 88 | 58 | 72 | 69 | 87 | 26 | 44 | 79 |
| Mₙ (g/mol) | 20000 | 30300 | 22400 | 22200 | 31600 | 26000 | 15000 | nd | nd |
| PDI | 1,62 | 1,49 | 1,65 | 1,52 | 1,48 | 1,69 | 1,72 | nd | nd |
| Td_{10%} (°C) | 403 | 406 | 391 | 380 | 389 | 390 | nd | nd | nd |
| T_{g}(°C) | -40 | -25 | -15 | -39 | -19 | -22 | nd | nd | nd |
| Tₘ(°C) | 111 | 106 | 41/109 | 36/105 | 28/116 | 54/127 | nd | nd | nd |
| T_{c}(°C) | 86 | 93 | 28/94 | 24/87 | 25/97 | 39/110 | nd | nd | nd |

Dans ce tableau, les trois lignes VDF init., TrFE init. et CoM init. donnent la composition molaire de chacun des monomères dans le mélange réactionnel ; les trois lignes VDF fin., TrFE fin. et CoM fin. donnent la composition molaire de chacun des motifs dans le terpolymère synthétisé ; la ligne TBPPI donne la proportion molaire d'amorceur utilisée ; la ligne Pₘₐₓ donne la pression maximale atteinte dans le réacteur lors de la polymérisation ; la ligne ΔP donne la chute de pression observée après l'exotherme lors de la réaction : la ligne Rend. donne le rendement massique obtenu ; la ligne Mₙ donne la masse molaire moyenne en nombre du terpolymère, telle que déterminée par chromatographie d'exclusion stérique avec un étalon polyméthacrylate de méthyle ; la ligne PDI donne l'indice de polydispersité, tel que déterminé par la même méthode ; la ligne Td_{10%} donne la température de dégradation de 10 % en masse du terpolymère, telle que déterminée par analyse thermogravimétrique sous air, à 10°C/min ; la ligne Tg donne la température de transition vitreuse du terpolymère, telle que déterminée par calorimétrie différentielle à balayage (DSC) ; la ligne Tₘ donne la température de fusion du terpolymère, telle que déterminée par calorimétrie différentielle à balayage (DSC) ; et la ligne T_{c} donne la température de cristallisation du terpolymère, telle que déterminée par calorimétrie différentielle à balayage (DSC).

## Revendications

1. Copolymère statistique et linéaire obtenu par copolymérisation de fluorure de vinylidène, de trifluoroéthylène et d'un moins un tiers monomère, le tiers monomère ayant une masse molaire supérieure à 100 g/mol et répondant à la formule : 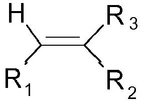 dans laquelle R₁ représente un atome d'hydrogène ou un atome de fluor, et R₂ et R₃ sont choisis, indépendamment l'un de l'autre parmi CI, F, CF₃, phosphonate, acide carboxylique, SO₂X où X représente F, OK, ONa, OH, ou Si(OR)₃, R représentant un groupement méthyle, éthyle ou isopropyle.

2. Copolymère selon la revendication 1, dans lequel le tiers monomère est choisi parmi le 2,3,3,3-tétrafluoropropène, le 2-chloro-3,3,3-trifluoropropène, l'acide α,β-difluoroacrylique, l'acide 2-(trifluoro)méthacrylique et le diméthylvinylphosphonate.

3. Copolymère selon la revendication 1 ou 2, dans lequel :
- la proportion molaire de motifs issus du monomère fluorure de vinylidène est de 40 à 90 %, de préférence de 55 à 80 % ;
- la proportion molaire de motifs issus du monomère trifluoroéthylène est de 5 à 50 %, de préférence de 10 à 40 % ; et
- la proportion molaire de motifs issus du tiers monomère est de 1 à 20 %, de préférence de 2 à 18 %.

4. Procédé de préparation d'un copolymère, comprenant une étape de copolymérisation d'un mélange réactionnel de fluorure de vinylidène, de trifluoroéthylène et d'au moins un tiers monomère ayant une masse molaire supérieure à 100 g/mol, le tiers monomère répondant à la formule : 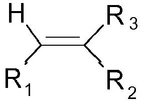 dans laquelle R₁ représente un atome d'hydrogène ou un atome de fluor, et R₂ et R₃ sont choisis, indépendamment l'un de l'autre parmi CI, F, CF₃, et les groupements fonctionnels sélectionnés parmi les groupements phosphonate, acide carboxylique, SO₂X où X représente F, OK, ONa, OH, ou Si(OR)₃, R représentant un groupement méthyle, éthyle ou isopropyle.

5. Procédé selon la revendication 4, dans lequel le tiers monomère est choisi parmi le 2,3,3,3-tétrafluoropropène, le 2-chloro-3,3,3-trifluoropropène, l'acide α,β-difluoroacrylique, l'acide 2-(trifluoro)méthacrylique et le diméthylvinylphosphonate.

6. Procédé selon la revendication 4 ou 5, dans lequel :
- la proportion molaire de fluorure de vinylidène dans le mélange réactionnel est de 40 à 90 %, de préférence de 55 à 80 % ;
- la proportion molaire de trifluoroéthylène dans le mélange réactionnel est de 5 à 50 %, de préférence de 10 à 40 % ; et
- la proportion molaire de tiers monomère dans le mélange réactionnel est de 1 à 20 %, de préférence de 2 à 18 % ;
les proportions molaires étant rapportées à la somme du fluorure de vinylidène, du trifluoroéthylène et du tiers monomère.

7. Procédé selon l'une des revendications 4 à 6, dans lequel le mélange réactionnel est dépourvu d'agent de transfert de chaîne.

8. Procédé selon l'une des revendications 4 à 7, dans lequel le mélange réactionnel consiste essentiellement en, et de préférence consiste en, un mélange de fluorure de vinylidène, de trifluoroéthylène, d'au moins un tiers monomère, d'amorceur radicalaire, et de solvant et / ou d'eau.

9. Procédé selon l'une des revendications 4 à 8, dans lequel le mélange réactionnel est chauffé jusqu'à une température de démarrage de réaction comprise entre 60 et 90°C, de préférence entre 70 et 80°C, et plus particulièrement entre 72 et 76°C.

10. Copolymère selon l'une des revendications 1 à 3, préparé par le procédé de l'une des revendications 4 à 9.

11. Film ou membrane comprenant au moins un copolymère selon l'une des revendications 1 à 3 ou 10.

12. Dispositif piézoélectrique comprenant un film selon la revendication 11.

13. Dispositif ferroélectrique comprenant un film selon la revendication 11.

14. Dispositif pyroélectrique comprenant un film selon la revendication 11.

15. Revêtement comprenant un film selon la revendication 11.

## Patentansprüche

1. Statistisches und lineares Copolymer, das durch Copolymerisation von Vinylidenfluorid, Trifluorethylen und mindestens einem dritten Monomer erhalten wird, wobei das dritte Monomer eine Molmasse von mehr als 100 g/mol aufweist und der folgenden Formel entspricht: 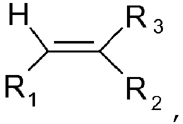 worin R₁ ein Wasserstoffatom oder ein Fluoratom darstellt und R₂ und R₃ unabhängig voneinander aus Cl, F, CF₃, Phosphonat, Carbonsäure, SO₂X, wobei X für F, OK, ONa oder OH steht, oder Si(OR)₃, wobei R eine Methyl-, Ethyl- oder Isopropylgruppe darstellt, ausgewählt sind.

2. Copolymer nach Anspruch 1, wobei das dritte Monomer aus 2,3,3,3-Tetrafluorpropen, 2-Chlor-3,3,3-trifluorpropen, α,β-Difluoracrylsäure, 2-(Trifluor)methacrylsäure und Dimethylvinylphosphonat ausgewählt ist.

3. Copolymer nach Anspruch 1 oder 2, wobei:
- der molare Anteil an Motiven, die von dem Vinylidenfluorid-Monomer herrühren, 40 bis 90%, vorzugsweise 55 bis 80% beträgt;
- der molare Anteil an Motiven, die von dem Trifluorethylen-Monomer herrühren, 5 bis 50%, vorzugsweise 10 bis 40% beträgt und
- der molare Anteil an Motiven, die von dem dritten Monomer herrühren, 1 bis 20%, vorzugsweise 2 bis 18% beträgt.

4. Verfahren zur Herstellung eines Copolymers, umfassend einen Schritt der Copolymerisation eines Reaktionsgemischs aus Vinylidenfluorid, Trifluorethylen und mindestens einem dritten Monomer, das eine Molmasse von mehr als 100 g/mol aufweist, wobei das dritte Monomer der folgenden Formel entspricht: 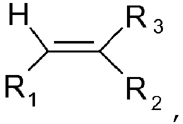 worin R₁ ein Wasserstoffatom oder ein Fluoratom darstellt und R₂ und R₃ unabhängig voneinander aus Cl, F, CF₃ und funktionellen Gruppen ausgewählt sind, die aus den Gruppen Phosphonat, Carbonsäure, SO₂X, wobei X für F, OK, ONa oder OH steht, oder Si(OR)₃, wobei R eine Methyl-, Ethyl- oder Isopropylgruppe darstellt, ausgewählt sind.

5. Verfahren nach Anspruch 4, wobei das dritte Monomer aus 2,3,3,3-Tetrafluorpropen, 2-Chlor-3,3,3-trifluorpropen, α,β-Difluoracrylsäure, 2-(Trifluor)methacrylsäure und Dimethylvinylphosphonat ausgewählt ist.

6. Verfahren nach Anspruch 4 oder 5, wobei:
- der molare Anteil an Vinylidenfluorid im Reaktionsgemisch 40 bis 90%, vorzugsweise 55 bis 80% beträgt;
- der molare Anteil an Trifluorethylen im Reaktionsgemisch 5 bis 50%, vorzugsweise 10 bis 40% beträgt und
- der molare Anteil des dritten Monomers im Reaktionsgemisch 1 bis 20%, vorzugsweise 2 bis 18% beträgt,
wobei die molaren Anteile sich auf die Summe von Vinylidenfluorid, Trifluorethylen und dem dritten Monomer beziehen.

7. Verfahren nach einem der Ansprüche 4 bis 6, wobei das Reaktionsgemisch kein Kettenübertragungsmittel enthält.

8. Verfahren nach einem der Ansprüche 4 bis 7, wobei das Reaktionsgemisch im Wesentlichen aus und vorzugsweise aus einem Gemisch von Vinylidenfluorid, Trifluorethylen, mindestens einem dritten Monomer, Radikalstarter und Lösungsmittel und/oder Wasser besteht.

9. Verfahren nach einem der Ansprüche 4 bis 8, wobei das Reaktionsgemisch bis auf eine Reaktionsinitiationstemperatur zwischen 60 und 90°C, vorzugsweise zwischen 70 und 80°C und ganz besonders zwischen 72 und 76°C erhitzt wird.

10. Copolymer nach einem der Ansprüche 1 bis 3, das durch das Verfahren nach einem der Ansprüche 4 bis 9 hergestellt wird.

11. Film oder Membran, umfassend mindestens ein Copolymer nach einem der Ansprüche 1 bis 3 oder 10.

12. Piezoelektrische Vorrichtung, die einen Film nach Anspruch 11 umfasst.

13. Ferroelektrische Vorrichtung, die einen Film nach Anspruch 11 umfasst.

14. Pyroelektrische Vorrichtung, die einen Film nach Anspruch 11 umfasst.

15. Beschichtung, die einen Film nach Anspruch 11 umfasst.

## Claims

1. A random linear copolymer obtained by copolymerization of vinylidene fluoride, of trifluoroethylene and of at least one third monomer, the third monomer having a molar mass of greater than 100 g/mol and corresponding to the formula: 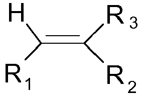 in which R₁ represents a hydrogen atom or a fluorine atom and R₂ and R₃ are chosen, independently of one another, from Cl, F, CF₃, phosphonate, carboxylic acid, SO₂X, where X represents F, OK, ONa or OH, or Si(OR)₃, R representing a methyl, ethyl or isopropyl group.

2. The copolymer as claimed in claim 1, in which the third monomer is chosen from 2,3,3,3-tetrafluoropropene, 2-chloro-3,3,3-trifluoropropene, α,β-difluoroacrylic acid, 2-(trifluoro)methacrylic acid and dimethyl vinylphosphonate.

3. The copolymer as claimed in claim 1 or 2, in which:
- the molar proportion of units resulting from the vinylidene fluoride monomer is from 40 to 90% and preferably from 55 to 80%;
- the molar proportion of units resulting from the trifluoroethylene monomer is from 5 to 50% and preferably from 10 to 40%; and
- the molar proportion of units resulting from the third monomer is from 1 to 20% and preferably from 2 to 18%.

4. A process for the preparation of a copolymer comprising a stage of copolymerization of a reaction mixture of vinylidene fluoride, of trifluoroethylene and of at least one third monomer having a molar mass of greater than 100g/mol, the third monomer corresponding to the formula: 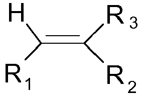 in which R₁ represents a hydrogen atom or a fluorine atom and R₂ and R₃ are chosen, independently of one another, from Cl, F, CF₃ and functional groups selected from phosphonate, carboxylic acid, SO₂X (where X represents F, OK, ONa or OH) or Si(OR)₃ (R representing a methyl, ethyl or isopropyl group) groups.

5. The process as claimed in claim 4, in which the third monomer is chosen from 2,3,3,3-tetrafluoropropene, 2-chloro-3,3,3-trifluoropropene, α,β-difluoroacrylic acid, 2-(trifluoro)methacrylic acid and dimethyl vinylphosphonate.

6. The process as claimed in claim 4 or 5, in which:
- the molar proportion of vinylidene fluoride in the reaction mixture is from 40 to 90% and preferably from 55 to 80%;
- the molar proportion of trifluoroethylene in the reaction mixture is from 5 to 50% and preferably from 10 to 40%; and
- the molar proportion of the third monomer in the reaction mixture is from 1 to 20% and preferably from 2 to 18%;
the molar proportions being with respect to the sum of the vinylidene fluoride, trifluoroethylene and third monomer.

7. The process as claimed in one of claims 4 to 6, in which the reaction mixture is devoid of chain-transfer agent.

8. The process as claimed in one of claims 4 to 7, in which the reaction mixture is essentially composed of and preferably consists of a mixture of vinylidene fluoride, of trifluoroethylene, of at least one third monomer, of radical initiator and of solvent and/or of water.

9. The process as claimed in one of claims 4 to 8, in which the reaction mixture is heated up to a temperature for initiation of reaction of between 60 and 90°C, preferably between 70 and 80°C and more particularly between 72 and 76°C.

10. The copolymer as claimed in one of claims 1 to 3 prepared by the process of one of claims 4 to 9.

11. A film or membrane comprising at least one copolymer as claimed in one of claims 1 to 3 or 10.

12. A piezoelectric device comprising a film as claimed in claim 11.

13. A ferroelectric device comprising a film as claimed in claim 11.

14. A pyroelectric device comprising a film as claimed in claim 11.

15. A coating comprising a film as claimed in claim 11.
